Europäisches Patentamt

European Patent Office

Office européen des brevets

(19)

(11) Numéro de publication: **0 003 193**
**B1**

(12) **FASCICULE DE BREVET EUROPEEN**

(45) Date de publication du fascicule de brevet: **12.08.81**

(51) Int. Cl.³: **G 11 C 11/34, H 01 L 27/02**

(21) Numéro de dépôt: **79400009.1**

(22) Date de dépôt: **04.01.79**

(54) Elément de mémoire statique à accès aléatoire.

(30) Priorité: **13.01.78 FR 7800933**

(43) Date de publication de la demande:
**25.07.79 Bulletin 79/15**

(45) Mention de la délivrance du brevet:
**12.08.81 Bulletin 81/32**

(84) Etats Contractants Désignés:
**DE GB NL**

(73) Titulaire: **THOMSON-CSF**
**173, Boulevard Haussmann**
**F-75360 Paris Cedex 08 (FR)**

(72) Inventeur: **Pham, Ngu Tung**
**"THOMSON-CSF" - SCPI 173, bld Haussmann**
**F-75360 Paris Cedex 08 (FR)**

(74) Mandataire: **Desperrier, Jean-Louis et al,**
**"Thomson-CSF" - SCPI 173, Bld Haussmann**
**F-75360 Paris Cedex 08 (FR)**

(56) Documents cités:
**FR - A - 2 269 788**
**FR - A - 2 288 372**
**FR - A - 2 309 084**
**FR - A - 2 341 232**
**FR - A - 2 344 187**
**US - A - 2 913 704**
**US - A - 3 909 807**
**US - A - 3 953 866**
**ELECTRONICS, vol. 49, n° 17**
**19 août 1976, New York**
**SANDER et al.: "Dynamic I²L Random-Access**
**Memory Comptes with MOS Designs", pages**
**99—102**

**IBM TECHNICAL DISCLOSURE BULLETIN,**
**Vol. 13, n° 9, février 1971,**
**ARMONK (USA)**
**CHIN: "Monolithic Dual Emitter SCR Random-**
**Access Memory Cell" page 2653**

**IBM TECHNICAL DISCLOSURE BULLETIN,**
**vol. 16, n° 12, Mai 1974,**
**ARMONK (USA)**
**DORLER et al.: "Complementary Transistor**
**Switch Memory Cell", pages 3931—3932**

**IBM TECHNICAL DISCLOSURE BULLETIN,**
**vol. 17, n° 6, november 1974,**
**ARMONK (USA)**
**DORLER et al.: "Lateral PNP Design for Memory**
**Cell" pages 1619—1620**

**IBM TECHNICAL DISCLOSURE BULLETIN**
**vol. 20, n° 9, février 1978,**
**ARMONK (USA)**
**MALAVIYA: "Single-Device DC Stable Memory**
**Cell" pages 3492—3494**

**IEEE INTERNATIONAL SOLID-STATE CIRCUITS**
**CONFERENCE,**
**Digest of Technical Papers, février 1973,**
**New York**
**DUNN et al.: "A Low Power Memory Cell for**
**Main Frame Memories" pages 66—67**

**TRANSACTIONS OF THE IECE OF JAPAN**
**vol. E60, n° 4, avril 1977,**
**Tokyo**
**HORIGUCHI et al.: "Realisation of Random**
**Access Memory using PNPN Switching**
**Devices", pages 217—218**

Courier Press, Leamington Spa, England.

## Elément de mémoire statique à accès aléatoire

Les mémoires statiques à accès aléatoires sont composées de matrices d'éléments actifs à deux états stables, l'un correspondant à l'état "0", l'autre à l'état "1". L'adressage de chaque élément pour la lecture ou l'écriture se fait par sélection de la ligne et de la colonne à l'intersection desquelles se trouve l'élément adressé.

La qualité et l'intérêt de chaque type de mémoire dépend essentiellement de la stabilité et de la dimension de chaque élément.

L'invention a pour but de fournir un élément de mémoire pouvant avoir une très faible surface, être facilement intégré, et par conséquent l'obtention de mémoires à grande densité d'intégration.

On connaît, par la publication "Transactions of the IECE of Japan, Vol. E 60, N° 4, Avril 77, Horiguchi et al.: "Realisation of Random Access Memory using PNPN switching Devices" un élément de mémoire statique à accès aléatoire comportant un premier et deuxième transistor complémentaires intégrés sur le même substrat, le collecteur du premier transistor constituant la base du second, et la base du premier constituant le collecteur du second. Le premier transistor comporte un premier émetteur éloigné de son collecteur et un deuxième émetteur, le premier émetteur étant alimenté en tension continu à travers une résistance. Un premier adressage en Y de la matrice de mémoire se fait sur le deuxième émetteur du premier transistor et un adressage en X de la matrice de mémoire se fait sur l'émetteur du deuxième transistor.

D'autre part, le fascicule de brevet FR-A-2344187 se rapporte à un élément pour circuit logique intégré comportant deux transistors complémentaires intégrés sur le même substrat, dont un transistor a son émetteur relié à une source de courant constant réalisée par un troisième transistor intégré sur le même substrat dont la base et l'émetteur sont portés à des potentiels fixes.

Suivant l'invention, un élément d'une matrice de mémoire statique à accès aléatoire comporte un premier et un deuxième transistor complémentaires intégrés sur le même substrat, le collecteur du premier transistor de type "latéral" constituant la base du deuxième de type "transversal", la base du premier constituant le collecteur du second, le premier transistor comportant un premier émetteur éloigné de son collecteur et un deuxième émetteur proche de ce collecteur, le premier émetteur étant relié à une source de courant constant constituée par un troisième transistor intégré sur le même substrat, dont la base et l'émetteur sont portés à des potentiels fixes. Un premier adressage en Y de la matrice de mémoire se fait sur le deuxième émetteur du premier transistor, et un adressage en X de la matrice de mémoire se fait sur l'émetteur du deuxième transistor. Cet élément de mémoire est caractérisé en ce qu'un deuxième adressage en Y se fait également par l'intermédiaire d'une diode Schottky constituée par un contact pris sur la base du premier transistor, ledit contact étant disposé entre le premier émetteur et le collecteur du premier transistor, le premier adressage en Y permettant le forçage de la bascule formée par l'ensemble des deux transistors à l'état passant et le deuxième adressage en Y permettant de forcer l'ensemble des deux transistors à l'état bloqué ou de lire l'information dans l'elément de la matrice de mémoire; l'adressage en X permettant soit l'écriture, soit la lecture.

L'invention sera mieux comprise au moyen de la description ci-après en se référant aux dessins annexés parmi lesquels:

—la figure 1 est le schéma de l'élément de mémoire selon l'inscription;

—la figure 2, une vue en coupe de cet élément intégré sur un substrat;

—la figure 3 représente le schéma d'une mémoire comportant les éléments selon l'invention;

—la figure 4 est un schéma d'ensemble du dispositif d'adressage en X;

—la figure 5 est un schéma plus détaillé de ce dernier dispositif;

—la figure 6 est un schéma du dispositif d'adressage en Y;

—la figure 7 est un détail du dispositif de la figure 6.

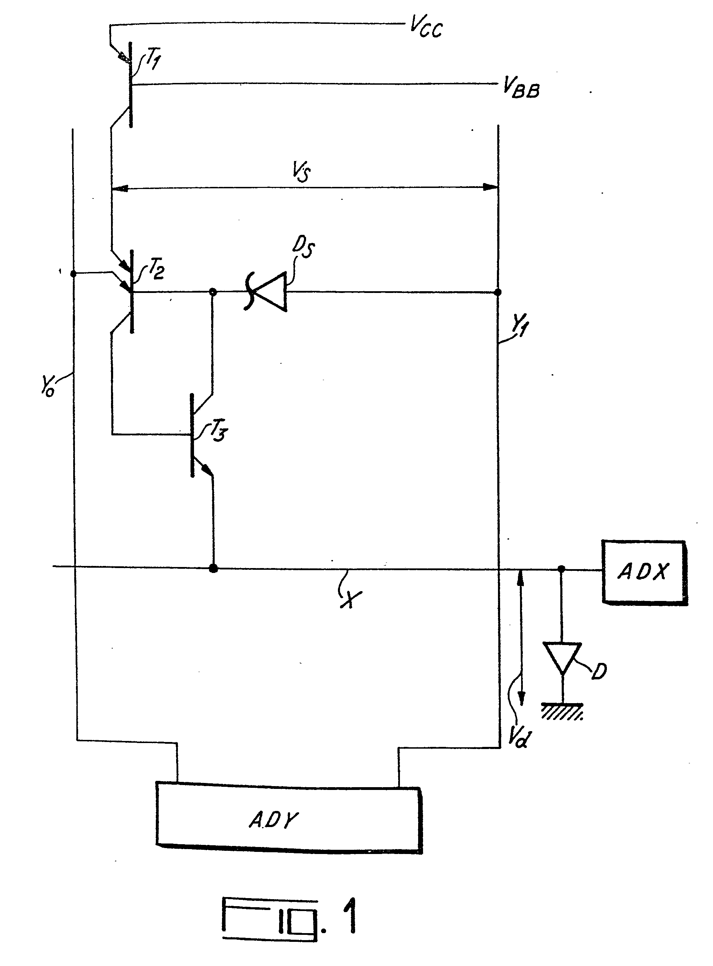

Sur la figure 1, on peut voir trois transistors $T_1$, $T_2$ et $T_3$. Le premier transistor $T_1$ du type p n p, a sa base et son émetteur portés à des potentiels fixes respectivement $V_{BB}$ et $V_{CC}$ et fonctionne donc en source de courant.

Son collecteur est relié à un premier émetteur du transistor $T_2$, du même type p n p. Cet émetteur est éloigné du collecteur du même transistor. Un autre émetteur du même transistor, beaucoup plus proche du collecteur est relié à une première ligne d'adressage $Y_0$, sa base par une diode Schottky à une autre ligne d'adressage $Y_1$, ces deux lignes étant reliées au même dispositif d'adressage ADY. Cette base est reliée d'autre part au collecteur du transistor $T_3$ du type n p n, la base de ce dernier étant reliée au collecteur du transistor $T_2$ et son émetteur étant relié à la ligne d'adressage en X. Cette ligne est reliée d'une part à la masse par une diode D passante de la ligne X à la masse, et d'autre part au dispositif d'adressage en X, dont le rôle essentiel est de court-circuiter la diode et de mettre la ligne X à la masse. Les deux dispositifs ADX et ADY seront décrits plus loin.

Quand les deux lignes $Y_0$ et $Y_1$ ne sont pas adressées, elles ont un potentiel flottant. Quand la ligne $Y_0$ est adressée, elle est portée à un potentiel $V_{Y0}$ fixe. Quand la ligne $Y_1$ est

adressée, elle peut être portée à un potentiel positif (potentiel $V_{Y1}$).

Quand la ligne X n'est pas adressée, elle est au potentiel 0,8 V (chute de tension aux bornes de la diode D). Quand elle est adressée elle est à la masse (potentiel "0").

On sait que l'ensemble $T_2$—$T_3$ peut prendre deux états stables, l'état conducteur, ou "passant" et l'état bloqué, ces deux états représentant respectivement les états "0" et "1" par convention.

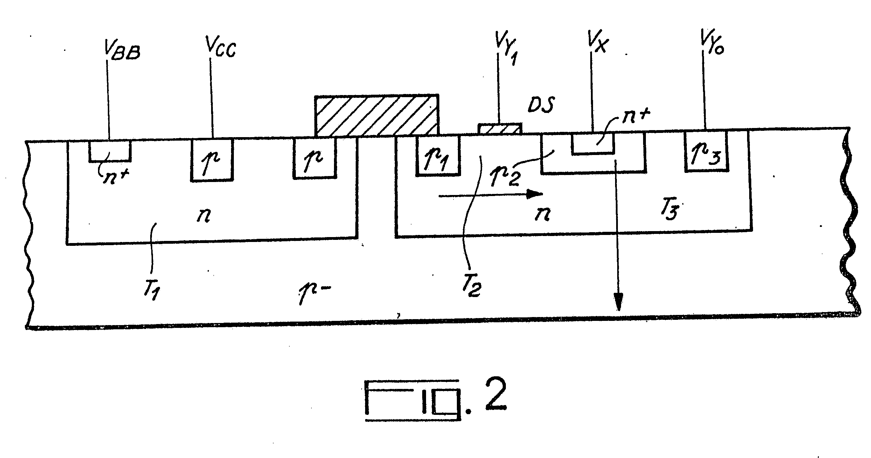

En figure 2 est représentée la structure en coupe transversale, intégrée sur le même substrat. On voit clairement le transistor $T_2$, du type p n p avec ses deux émetteurs $p_1$ et $p_3$, l'un $p_1$, éloigné du collecteur $p_2$, l'autre $p_3$ proche de celui-ci. La tension $Y_1$ appliquée à une zone métallique DS, formant une diode Schottky avec la base n et située entre l'émetteur et le collecteur. Les transistors $T_1$, et $T_2$—$T_3$ sont respectivement dans deux caissons de type n pratiqués par des moyens connus, dans le substrat de type p. L'émetteur de $T_2$ est relié au collecteur du transistor $T_1$.

On voit que le système $p_1$ n $p_2$ n+ a une base contrôlée par la diode Schottky DS de largeur relativement grande. Le transistor $p_1$ n $p_2$ a un gain très faible, et la structure ne peut donc pas commuter d'un état à l'autre sans influence extérieure. Par contre, le système $p_3$ n $p_2$ n+ peut être commuté par action sur l'émetteur $p_3$. Or, c'est cet émetteur qui est connecté à la ligne d'adressage $Y_0$. Une fois à l'état passant, même non adressé, le système se maintient à l'état passant grâce au courant fourni par la source de courant que constitue le transistor $T_1$.

Le tableau suivant résume les états possibles de la cellule dans lequel on a:

$V_{Xoff}$: tension de $V_X$ quand la cellule n'est pas adressée (ici 0,8 V, tension aux bornes de la diode D passante);

$V_{Xon}$: tension d'adressage sur la ligne X (ici $V_{Xon} = 0$);

$V_d$: tension aux bornes de la diode quand elle est passante;

$V_s$: tension aux bornes de la diode Schottky quand elle est passante;

$V_{Y0}$: tension appliquée à la ligne $Y_0$ pour forcer la cellule à l'état "0" (cellule passante);

$V_{Y1}$: tension appliquée à la ligne $Y_1$ pour forcer la cellule à l'état "1" (cellule bloquée);

On a d'abord les conditions:

(1)    $V_{Y0} - V_{Xoff} < V_d$
(2)    $V_{Y1} - V_{Xoff} < V_s$

Ces deux conditions sont respectivement les conditions de stabilité à l'état bloqué et passant de la cellule quand elle n'est pas adressée.

Dans le cas présent $V_{Xoff} = V_d$
Ces conditions s'écrivent:

(1)    $V_{Y0} < 2V_d$

(2)    $V_{Y1} < V_d + V_s$

Les deux conditions suivantes sont les conditions de forçage respectif à l'état "1" et à l'état "0":

$$V_{Y0} - V_{Xon} > V_d$$
$$V_{Y1} - V_{Xon} > V_s$$

ou comme $V_{Xon} = 0$

(3)    $V_{Y0} > V_d$
(4)    $V_{Y1} > V_s$

On voit donc que pour agir sur une cellule, il faut: mettre $V_X$ à la masse, ce qui affecte une ligne de la matrice de mémoire et changer son état par une de ses deux lignes $Y_0$ ou $Y_1$ une fois ces lignes adressées.

En appliquant sur la ligne $Y_0$ la tension $V_{Y0}$, on force la cellule à l'état "0", équation (3), ou on la maintient à cet état si $V_{Y0} < 2V_d$, équation (1).

De même en appliquant sur la ligne $Y_1$ la tension $V_{Y1}$, on la force à l'état "1" (bloqué) si $V_{Y1} > V_s$, et on l'y maintient si $V_{Y1} < V_s + V_d$. La lecture se fait en appliquant la tension $X_{on}$ sur la ligne sélectionnée et en adressant les lignes $Y_0$ et $Y_1$. La lecture est la mesure de la tension de sortie sur la ligne $Y_1$.

A l'état "0", l'ensemble $T_2$—$T_3$ est passant, la ligne $Y_1$ est au potentiel "0"

A l'état "1", l'ensemble est bloqué, la ligne $Y_1$ est déconnectée son potentiel est différent de "0".

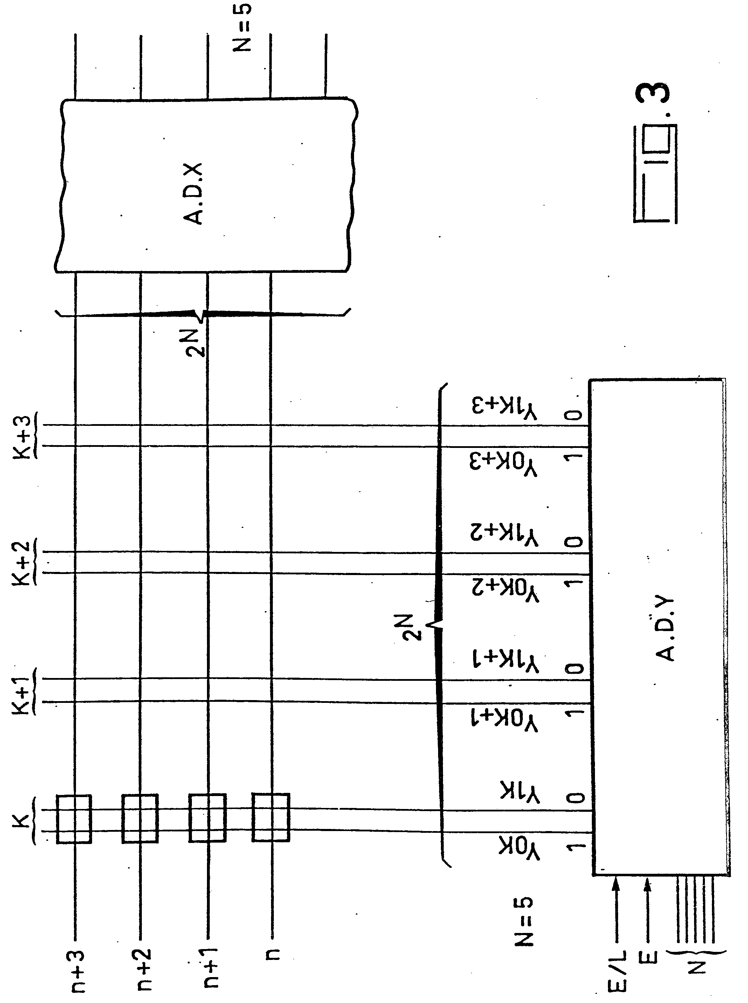

La figure 3 représente le schéma d'une mémoire à accès aléatoire utilisant les éléments de mémoire selon l'invention.

Les éléments sont placés en lignes X et en colonnes Y.

Chaque ligne X, (ici seules les lignes de rangs respectifs n, n+1, n+2, n+3 sont représentées) est connectée au système d'adressage en X, ADX qui a $2^N$ sorties et N entrées, N étant bien entendu un nombre entier, $2^N$ étant les nombres de lignes.

Chaque colonne Y comprend les deux lignes de connexion $Y_{1K}$ et $Y_{0K}$.

Les paires de colonnes au nombre de $2^N$ sont connectées au système d'adressage en Y, ADY qui a tout d'abord N entrées et deux entrées supplémentaires, l'une, l'entrée E/L qui assigne les fonctions alternativement d'écriture ou de lecture de l'information de l'élément choisi, la deuxième E est une entrée qui commute la ligne $Y_0$ à une tension $V_{Y0}$ si on veut écrire un "0", ou la ligne $Y_1$ à une tension $V_{Y1}$, si on veut écrire un "1". Il comporte enfin N entrées d'adressage $e_1 \ldots e_N$.

Le fonctionnement de l'ensemble se comprend aisément. Par le dispositif ADX, une ligne de la matrice est sensibilisée, c'est-à-dire que tous ses éléments et eux seuls, sont capables de recevoir une information, leur ligne étant à la masse.

L'entrée E/L indique au dispositif ADY la fonction qu'il doit assumer, lecture ou écriture.

Dans les deux cas, une colonne est choisie. Donc seul l'élément à la croisée de la ligne choisie par le dispositif ADX et de la colonne choisie par ADY est capable d'enregistrer l'information "1" ou "0" ou de la restituer suivant l'ordre reçu par l'entrée E/L.

Dans le cas où l'ordre d'enregistrement est donné, il enregistre l'état "0" ou "1" suivant la tension de l'entrée E. Dans le cas de la lecture, il délivre l'information qu'il contient, suivant le processus qui a été décrit plus haut.

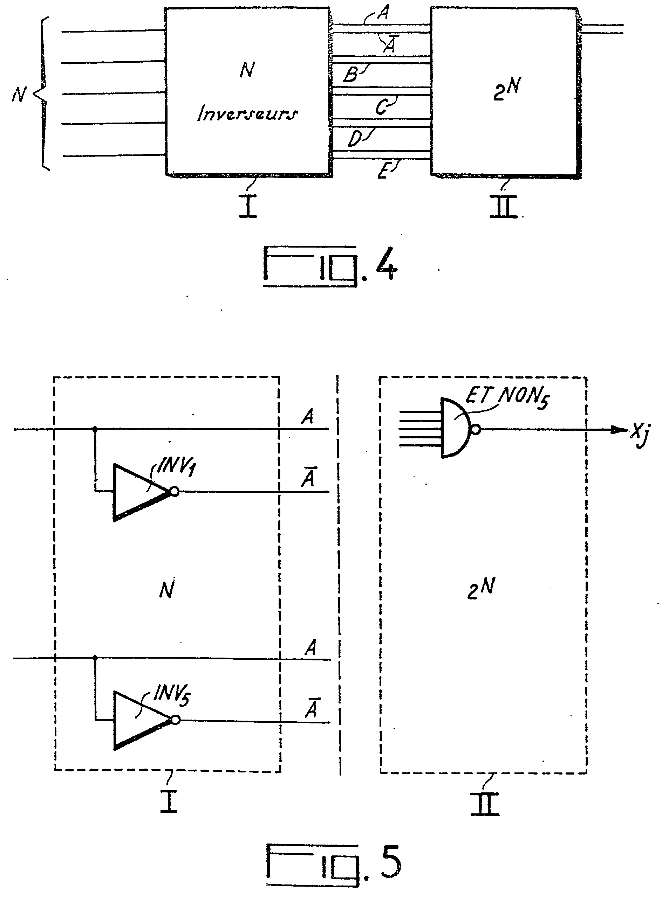

La figure 4 représente le schéma du dispositif ADX.

Il comprend N inverseurs logiques groupés dans le bloc I, et $2^N$ portes groupées dans l'ensemble II.

On a pris ici N=5, pour faciliter l'exposé, $2^N$ étant égal par conséquent à 32.

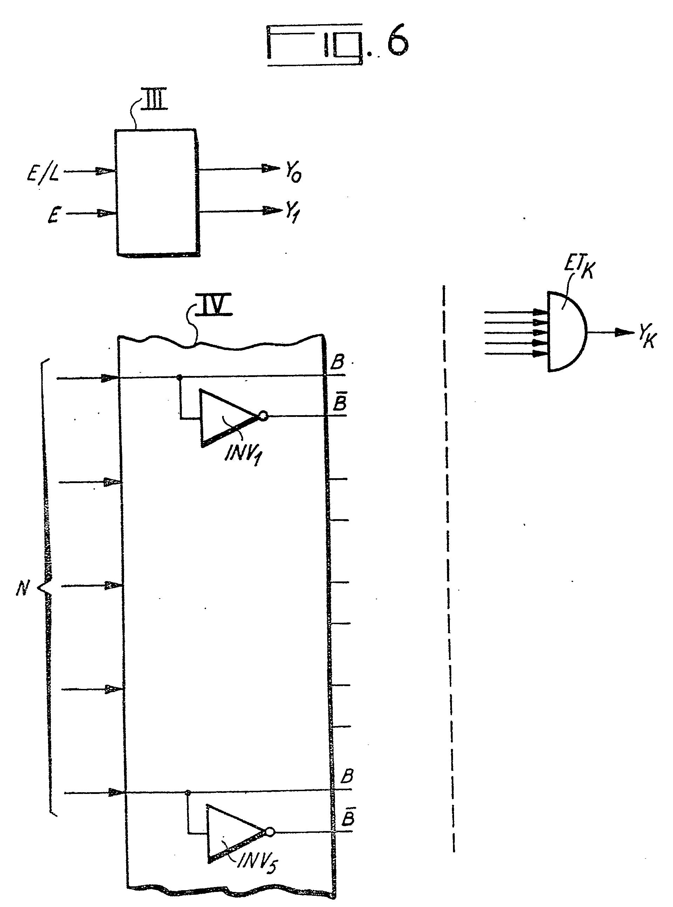

Les inverseurs sont montés comme indiqué figure 5. Il en résulte qu'à chaque entrée de l'ensemble I, correspond deux sorties complémentaires A et $\overline{A}$.

L'ensemble II comprend 32 portes ET-NON, dont les sorties respectives se mettent à l'état "0", quand les cinq entrées sont à l'état "1". Chacune de ces portes porte un numéro de 0 à 31.

Or, de chaque ligne A ou $\overline{A}$, toujours l'une par définition est portée au niveau 1. De plus chaque nombre de 0 à 31, en numérotation binaire est un nombre de cinq chiffres, dont chacun est ou 1 ou 0. Le nombre 3 s'écrit par exemple 00011.

Pour exciter la porte 3, il suffira qu'elle soit reliée aux lignes $\overline{A}$, $\overline{B}$, $\overline{C}$ qui sont au niveau 1, et aux lignes D et E qui sont également au niveau 1, puisque A, B, C sont au niveau 0.

Par construction du dispositif ADX si on applique aux entrées de l'ensemble les chiffres binaires qui composent le nombre j, on adresse la ligne $X_j$.

Ceci étant, le problème à résoudre est de sélectionner un élément de la ligne $X_j$, celui de la colonne $Y_K$ pour d'une part, écrire une information, ou d'autre part pour lire l'information qu'il contient. C'est le rôle du système ADY que l'on va décrire à l'aide des figures suivantes.

Le schéma unifilaire du dispositif d'adressage est représenté à la figure 6. Il comprend deux organes principaux, à savoir l'organe de commande III et l'organe d'adressage IV. L'organe IV est identique aux organes I et II de la figure 4, à ceci près qu'à chaque colonne correspond un circuit ET dont la sortie se met à l'état "1" quand toutes ses entrées sont à l'état "1".

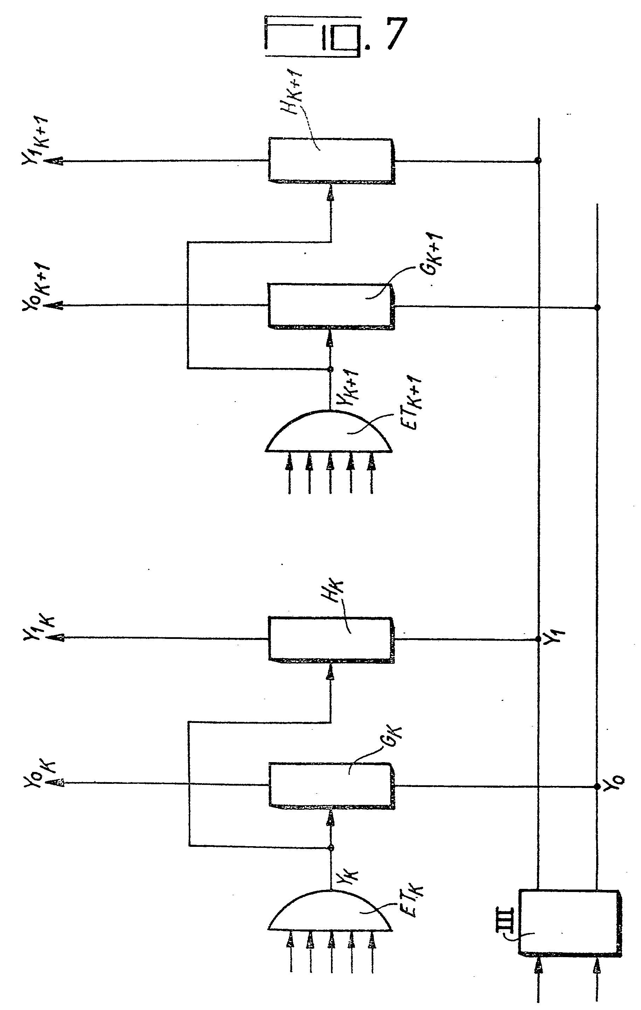

La fonction de cet organe sera précisée lors de la description de la figure 7.

L'organe de commande III comprend deux entrées, à savoir l'entrée E/L, qui commande la fonction écriture ou lecture de l'information et l'entrée E, qui dans le cas de l'écriture, commande l'entrée d'un "0" ou d'un "1". Il a deux sorties "bus" $Y_0$ et $Y_1$ qui sont reliées à chaque colonne de la matrice, comme on va le voir à la figure 7.

L'entrée E est reliée à une source de tension à deux niveaux "0" et "1".

Quand elle est à l'état "1", elle porte la ligne $Y_1$ à un potentiel $V_{Y1}$, quand elle est à l'état "0", elle porte le potentiel de la ligne $Y_0$ au potentiel $V_{Y0}$. L'entrée E/L en position L permet de lire l'information contenue dans l'élément adressé.

L'ensemble IV d'adressage en Y est identique à l'ensemble ADX, à ceci près que les inverseurs sont des portes ET à cinq entrées, qui se mettent à l'état "1", quand toutes les entrées sont à l'état "1" et restent à "0" dans le cas contraire.

Ces portes $ET_K$ (figure 7), une par colonne commandent chacune deux interrupteurs $G_K$ et $H_K$ qui, quand ils sont en position "1", connectent les lignes $Y_0$ et $Y_1$ respectivement aux deux lignes $Y_{0K}$ et $Y_{1K}$ qui sont affectées à chaque colonne de la matrice.

Il s'ensuit que l'inscription ou la lecture ne se font pour chaque colonne que lorsque la porte correspondante est ouverte.

Il est bien évident que tous ces ensembles logiques peuvent être réalisés au moyen de circuits intégrés à transistors bipolaires, en particulier un ensemble peut comprendre des bascules à transistors complémentaires p n p et n p n tels que ceux qui sont utilisés dans chaque élément de mémoire.

## Revendications

1. Elément d'une matrice de mémoire statique à accès aléatoire, comportant un premier ($T_2$) et un deuxième ($T_3$) transistor complémentaire intégrés sur le même substrat, le collecteur du premier transistor de type "latéral" constituant la base du deuxième de type "transversal", la base du premier constituant le collecteur du second, le premier transistor ($T_2$) comportant un premier émetteur éloigné de son collecteur et un deuxième émetteur proche de ce collecteur, le premier émetteur étant relié à une source de courant constant constituée par un troisième transistor ($T_1$) intégré sur le même substrat, dont la base et l'émetteur sont portés à des potentiels fixes ($V_{BB}$, $V_{CC}$), un premier adressage en Y de la matrice de mémoire se faisant sur le deuxième émetteur du premier transistor, et un adressage en X de la matrice de mémoire sur l'émetteur du deuxième transistor, caractérisé en ce qu'un deuxième adressage en Y se fait également par l'intermédiaire d'une diode Schottky ($D_S$) constituée par un contact pris sur la base du premier transistor, ledit contact étant disposé entre le premier émetteur et le collecteur du premier transistor, le premier adressage en Y permettant le forçage de la bascule formée par l'ensemble des deux transistors à l'état passant et le deuxième adressage en Y permettant de forcer la bascule à l'état bloqué ou de lire l'information dans l'élement de la matrice de mémoire, l'adressage en X permettant soit l'écriture, soit la lecture.

2. Elément suivant la revendication 1, caractérisé en ce que l'adressage en X se fait en portant à la masse l'émetteur du deuxième transistor.

3. Mémoire à accès aléatoire, comportant une matrice d'éléments selon l'une des revendications 1 et 2, caractérisée en ce qu'elle comporte pour chaque ligne, une ligne d'adressage (X) et pour chaque colonne deux lignes d'adressage ($Y_0$, $y_1$).

4. Mémoire selon la revendication 3, caractérisée en ce qu'elle comporte $2^N$ colonnes et $2^N$ lignes et en ce que les adressages en X et en Y comportent respectivement N entrées pouvant prendre le niveau "0" ou "1", ces niveaux constituant en numérotation binaire un des nombres de 1 à $2^N$ et 2N sorties formant N paires, une de ces sorties étant reliée directement à l'entrée correspondante, et l'autre à ladite entrée par l'intermédiaire d'un inverseur, l'ensemble de ces sorties étant groupé par groupes de N sorties, chaque groupe étant connecté aux N entrées d'une porte dont la sortie est connectée à une ligne ou à une colonne de la matrice, la porte d'adressage d'une ligne étant du type ET-NON, sa sortie mettant la ligne d'adressage en X correspondante à la masse, la porte d'adressage d'une colonne étant du type ET, sa sortie quand elle est au niveau 1, mettant les deux lignes d'adressage d'une colonne en communication avec les deux lignes d'écriture ou de lecture.

## Claims

1. An undetermined input static memory matrix component, comprising a first transistor ($T_2$) and a complementary second transistor ($T_3$) which are integrated on the same substrate, the collector of the first transistor, of the "lateral" type, constituting the base of the second transistor, of the "transverse" type, the base of the first transistor constituting the collector of the second transistor, said first transistor ($T_2$) comprising a first emitter spaced from the collector thereof and a second emitter located near said collector, said first emitter being connected to a constant current source constituted by a third transistor ($T_1$) integrated on the same substrate, the base and the emitter of which are maintained at fixed potentials ($V_{BB}$, $V_{cc}$), a first addressing along a line Y of the memory matrix being effected on the second emitter of the first transistor, and an addressing along a line X of the memory matrix being effected on the emitter of the second transistor, characterized in that a second addressing along Y is also effected through a Schottky diode ($D_s$) constituted by a contact established on the base of the first transistor, said contact being located between the first emitter and the collector of the first transistor; said first addressing along Y enabling to force the flip-flop circuit constituted by the combination of two transistors in the conductive state, and the second addressing along Y enabling to force the flip-flop circuit in the blocked state or to read the information in the memory matrix component, while the addressing along X allows either the recording or the read-out to be effected.

2. Component according to claim 1, characterized in that the addressing along X is effected by connecting the emitter of the second transistor to the ground.

3. Undetermined input memory, comprising a matrix including components according to any one of claims 1 and 2, characterized in that it comprises, for each row one addressing line (X) and, for each column, two addressing lines ($Y_0$, $Y_1$).

4. Memory according to claim 3, characterized in that it comprises $2^N$ columns and $2^N$ lines, and in that the addressing lines along X and along Y comprise, respectively, N inputs which may be brought to a power level "0" or a power level "1", said levels constituting in binary numbering one of the numbers comprised between 1 and $2^N$, and 2N outputs constituting N pairs, one of said outputs being connected directly to the corresponding input, and the other one being connected to said input through an inverter, all these outputs being grouped so as to form groups including N outputs, each group being connected to the N inputs of a gate, the output of which is connected to a row or a column of the matrix, the addressing gate of one line being of the type AND-NO, the output thereof connecting the corresponding addressing line X to the ground, the addressing gate of one column being of the type AND, the output thereof, when being at level 1, connecting the two addressing lines of a column to the two recording or read-out lines.

## Patentansprüche

1. Matrizenbauteil eines statischen Speichers mit unbestimmtem Einlass, umfassend einen ersten Transistor ($T_2$) und einen zweiten, denselben ergänzenden Transistor ($T_3$), welche Transistoren auf derselben Trägerschicht integriert sind, wobei der Kollektor des ersten zum "Lateraltyp" gehörigen Transistors die Basis des zum "Transversaltyp" gehörigen zweiten Transistors bildet und der erste Transistor ($T_2$) einen ersten, im Abstand von seinem Kollektor angeordneten Emitter und einen zweiten, in Nähe dieses Kollektors angeordneten Emitter besitzt, und wobei der erste Emitter an eine aus einem auf der gleichen Trägerschicht integrierten dritten Transistor ($T_1$) bestehende konstante Stromquelle angeschlossen ist, während die Basis und der Emitter dieses dritten Transistors an bestimmten Potentialen ($V_{BB}$, $V_{cc}$) liegen, eine erste Adressierung in Y-Richtung der Speichermatrize am zweiten Emitter des ersten Transistors, sowie eine Adressierung in X-Richtung der Speichermatrize am Emitter des zweiten Transistors erfolgt, dadurch gekennzeichnet, dass ferner eine zweite Adressierung in Y-Richtung vermittels einer Schottky-Diode $(D_s)$ erfolgt, die einen zwischen dem ersten Emitter und dem Kollektor des ersten Transistors liegenden Anschlusskontakt an der Basis des ersten Transistors umfasst, wobei die erste Adressierung in Y-Richtung die Auslösung der durch zwei Transistoren gebildeten Kippschaltung im Leitzustand, und die zweite Adressierung in Y-Richtung die Auslösung der Kippschaltung im Sperrzustand ermöglicht, bzw. die Meldung im Speichermatrizen-Bauteil abzulesen gestattet, während die Adressierung in X-Richtung entweder die Aufnahme oder das· Ablesen ermöglicht.

2. Bauteil nach Anspruch 1, dadurch gekennzeichnet, dass die Adressierung in X-Richtung derart erfolgt, dass der Emitter des zweiten Transistors auf das Erdpotential gebracht wird.

3. Speicher mit unbestimmten Einlass, der eine Bauteilmatrize nach einem der Ansprüche 1 und 2 aufweist, dadurch gekennzeichnet, dass er pro Reihe eine Adressierleitung (X) und pro Kolonne zwei Adressierleitungen $(Y_0, Y_1)$ aufweist.

4. Speicher nach Anspruch 3, dadurch gekennzeichnet, dass er $2^N$ Kolonnen und $2^N$ Reihen aufweist, und dass die Adressierleitungen in X-Richtung und in Y-Richtung jeweils N Eingänge besitzen, welche auf den Pegel "0" oder auf den Pegel "1" gebracht werden können, wobei diese Pegel im Binärsystem eine Grösse von 1 bis $2^N$ darstellen, sowie 2N Ausgänge, die N Ausgangspaare bilden, während einer dieser Ausgänge unmittelbar mit dem entsprechenden Eingang und der Ausgang über einen Wendeschalter mit dem genannten Eingang verbunden ist und wobei all Ausgänge in Form von jeweils N Ausgänge umfassenden Gruppen zusammengefasst sind, und wobei jede Gruppe an N Eingänge eines angeschlossen ist, dessen Ausgang an eine Reihe oder eine Kolonne der Matrize angeschlossen und die Anordnung derart ist, dass das Adressierungsgatter einer Reihe vom Typ UND-NEIN und sein Ausgang die entsprechende Adressierleitung in X-Richtung erdet, während das zum UND-Typ gehörige Gatter einer Kolonne, wenn sein Ausgang den Pegel "1" besitzt, die beiden Adressierungsleitungen einer Kolonne mit den beiden Aufnahme= oder Ableseleitungen verbindet.

Fig. 1

$V_{BB}$  $V_{CC}$  $V_{Y_1}$  $V_X$  $V_{Y_0}$

DS

$n^+$

$p$  $p$  $p_1$  $n^+$  $p_3$

$p_2$

$n$  $n$  $T_3$

$T_1$  $p^-$  $T_2$

Fig. 2

Fig.3

Fig.4

Fig.5

Fig. 6